# EUROPEAN PATENT SPECIFICATION

(11) **EP 2 183 333 B1**
(45) Date of publication and mention of the grant of the patent: **07.09.2016**
(21) Application number: 08794699.2
(22) Date of filing: 24.07.2008
(51) Int. Cl.: C09K 3/14, C09G 1/02, B24B 37/00, H01L 21/302, G11C 13/00

(54) **COMPOSITIONS AND METHODS FOR CHEMICAL-MECHANICAL POLISHING OF PHASE CHANGE MATERIALS**
ZUSAMMENSETZUNGEN UND VERFAHREN FÜR CHEMISCH-MECHANISCHES POLIEREN VON LATENTWÄRMESPEICHERN
COMPOSITIONS ET PROCÉDÉS POUR LE POLISSAGE CHIMICO-MÉCANIQUE DE MATIÈRES À CHANGEMENT DE PHASE

(30) Priority: 26.07.2007 US 962105 P
(43) Date of publication of application: 12.05.2010
(73) Proprietor: Cabot Microelectronics Corporation, Aurora, Illinois 60504 (US)
(72) Inventor: CHEN, Zhan, Aurora, Illinois 60504 (US); LUO, Kai, Aurora, Illinois 60504 (US); VACASSY, Robert, Aurora, Illinois 60504 (US)
(74) Representative: Trueman, Lucy Petra
(86) International application number: PCT/US2008/008978
(87) International publication number: WO 2009/017652

(56) References cited:
- CN-A- 1 616 572
- TW-A- 200 907 036
- US-A1- 2006 011 959
- US-A1- 2006 216 935
- US-B2- 6 544 892
- US-B2- 7 001 253

## Description

### FIELD OF THE INVENTION

This invention relates to polishing compositions and methods for polishing a substrate using the same. More particularly, this invention relates to chemical-mechanical polishing compositions suitable for polishing substrates comprising a phase change material, such as a germanium-antimony-tellurium alloy.

### BACKGROUND OF THE INVENTION

PRAM (Phase Change Random Access Memory) devices (also known as Ovonic memory devices or PCRAM devices) utilize a phase change material (PCM) that can be electrically switched between an insulating amorphous phase and conductive crystalline phase for electronic memory applications. Typical phase change materials suited for these applications utilize various Group VIB (chalcogenide, e.g., Te or Po) and Group VB (e.g., Sb) elements of the periodic table in combination with one or more metallic element, such as In, Ge, Ga, Sn, or Ag. Particularly useful phase change materials are germanium (Ge)-antimony (Sb)-tellurium (Te) alloys (GST alloys), such as an alloy having the formula Ge₂Sb₂Te₅ (GST225). These materials can reversibly change physical states depending on heating/cooling rates, temperatures, and times. Other useful alloys include indium antimonite (InSb). The memory information in a PRAM device is preserved with minimal loss through the conductive properties of the different physical phases or states.

Compositions and methods for chemical-mechanical polishing (CMP) the surface of a substrate are well known in the art. Polishing compositions (also known as polishing slurries, CMP slurries, and CMP compositions) for polishing metal-containing surfaces of semiconductor substrates (e.g., integrated circuits) typically contain abrasives, various additive compounds, and the like, and frequently are used in combination with an oxidizing agent.

In conventional CMP techniques, a substrate carrier (polishing head) is mounted on a carrier assembly and positioned in contact with a polishing pad in a CMP apparatus. The carrier assembly provides a controllable pressure ("down force" or "down pressure") to urge the substrate against the polishing pad. The pad and carrier, with its attached substrate, are moved relative to one another. The relative movement of the pad and substrate serves to abrade the surface of the substrate to remove a portion of the material from the substrate surface, thereby polishing the substrate. The polishing of the substrate surface typically is further aided and controlled by the chemical activity of the polishing composition (e.g., due to oxidizing agents, chelating agents, corrosion inhibitors, acids, and the like present in the CMP composition) and/or the mechanical activity of an abrasive suspended in the polishing composition. Typical abrasive materials include, for example, silicon dioxide (silica), cerium oxide (ceria), aluminum oxide (alumina), zirconium oxide (zirconia), titanium dioxide (titania), and tin oxide.

U.S. Pat. No. 5,527,423 to Neville et al., for example, describes a method for chemically-mechanically polishing a metal layer by contacting the surface of the metal layer with a polishing slurry comprising high purity fine metal oxide particles suspended in an aqueous medium. Alternatively, the abrasive material may be incorporated into the polishing pad.

U.S. Pat. No. 5,489,233 to Cook et al. discloses the use of polishing pads having a surface texture or pattern, and U.S. Pat. No. 5,958,794 to Bruxvoort et al. discloses a fixed abrasive polishing pad.

US6544892 B2 to Srinivasan relates to an aqueous slurry for removing silicon dioxide in preference to silicon nitride by chemical-mechanical processing and method of removing silicon dioxide in preference to silicon nitride from a surface of an article by chemical-mechanical polishing. The aqueous slurry includes abrasive particles and an organic compound having both a carboxylic acid functional group and a second functional group selected from amines and halides.

CN 1616572 A to Zhang et al.relates to nano polishing liquid for chemical and mechanical polishing (CMP) of phase changing sulfuric compound film material GeₓSb_{y}Te_{(1-x-y)} and its application in preparing nanometer electronic device phase changing storing material. The nano CMP liquid includes oxidant, chelating agent, pH regulator, nanometer grinding agent, anticorrosive agent, surfactant, solvent.

CMP techniques can be utilized to manufacture memory devices employing phase change materials; however, current CMP compositions often do not provide sufficient planarity when utilized for polishing substrates including relatively soft phase change materials, such as a GST or InSb alloy. In particular, the physical properties of many phase change materials (e.g., GST or InSb) make them "soft" relative to other materials utilized in PCM chips. For example, typical CMP polishing slurries containing relatively high solids concentrations (e.g., > about 3%) remove a phase change material (e.g., a GST alloy) through the mechanical action of the abrasive particles, resulting in heavy scratching on the surface of the phase change material. When such high solids CMP compositions are used, phase change material residues often remain on the underlying dielectric film after polishing, since the CMP slurry is not able to remove all of the phase change material. The phase change material residues cause further integration issues in subsequent steps of device manufacturing.

Co-owned and co-pending U.S. Patent Application Serial No. 11/699,129 describes CMP compositions and methods for polishing a phase change material employing a particulate abrasive in combination with at least one chelating agent, an optional oxidizing agent, and an aqueous carrier. The abrasive material is present in the composition at a concentration of not more than about 3 percent by weight. The chelating agent comprises a compound or combination of compounds capable of chelating a PCM or component thereof (e.g., germanium, indium, antimony and/or tellurium species) that is present in a substrate being polished, or chelating a substance (e.g., an oxidation product) that is formed from the PCM during polishing of the substrate with the CMP composition.

One drawback of CMP compositions for polishing phase change materials (e.g., GST) employing oxidizing agents, is that an oxide coating can build up on the surface of the PCM, which can degrade the electrical performance of the PCM device. There is an ongoing need to develop new CMP compositions that reduce the level of PCM oxide build-up on the surface of the substrate, while still providing acceptably rapid removal of phase change materials compared to conventional CMP compositions. The present invention provides such improved CMP compositions. These and other advantages of the invention, as well as additional inventive features, will be apparent from the description of the invention provided herein.

### BRIEF SUMMARY OF THE INVENTION

The present invention provides a method of polishing a phase change material-containing substrate, the method comprising abrading the surface of the substrate with a CMP composition comprising a) a particulate abrasive b) lysine; and c) an aqueous carrier therefor in the presence of an oxidising agent.

### BRIEF DESCRIPTION OF THE DRAWINGS

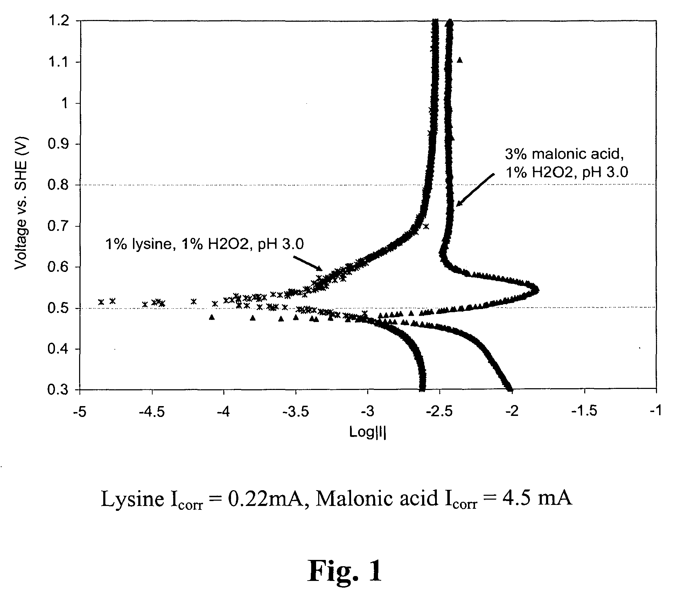

FIG. 1 shows a Tafel (voltage versus log-current) plot of electrochemical corrosion of a GST electrode in contact with an aqueous solution containing about 1 percent by weight lysine and about 1 percent by weight hydrogen peroxide at a pH of about 3, compared to corrosion of a GST electrode in contact with an aqueous solution containing about 3 percent by weight malonic acid and about 1 percent by weight hydrogen peroxide at a pH of about 3.

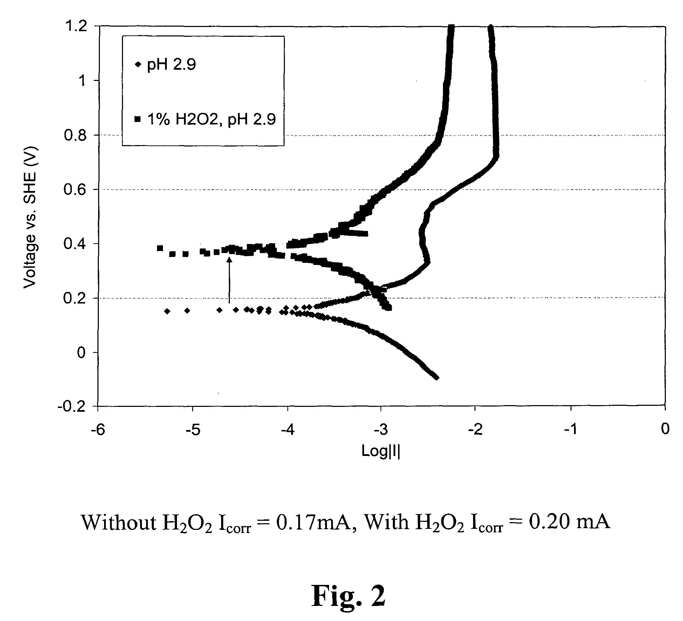

FIG. 2 shows Tafel plots of electrochemical GST corrosion obtained in 1 percent by weight aqueous hydrogen peroxide at pH 2.9, compared to water at pH 2.9.

### DETAILED DESCRIPTION OF THE INVENTION

Disclosed is a CMP composition useful for polishing a substrate containing a phase change material in the presence of an oxidizing agent. The CMP compositions disclosed provide for even removal of PCMs while reducing the level of PCM oxide build-up on the surface of the substrate relative to conventional CMP compositions. The CMP compositions disclosed contain a particulate abrasive material and lysine in an aqueous carrier such as water (e.g., deionized water). The compositions may include a chelating agent that is capable of chelating a PCM or a component thereof (e.g., germanium, indium, antimony and/or tellurium species) present in the substrate being polished or capable of chelating a substance formed from the PCM during the polishing process (e.g., an oxidation product formed from the PCM). The composition may also comprise an oxidizing agent.

Disclosed particulate abrasives useful in the CMP compositions that are disclosed include any abrasive material suitable for use in CMP of semiconductor materials. Disclosed examples of suitable abrasive materials include silica (e.g., fumed silica and/or colloidal silica), alumina, titania, ceria, zirconia, or a combination of two or more of the foregoing abrasives, which are well known in the CMP art. Preferred disclosed metal oxide abrasives include colloidal silica, fumed silica, and alpha-alumina. The disclosed abrasive material preferably is present in the composition in an amount of not more than about 6 percent by weight. Preferably, the disclosed abrasive material is present in the CMP composition at a concentration in the range of about 0.001 to about 6 percent by weight, more preferably in the range of about 0.01 to about 5 percent by weight, most preferably in the range of about 0.1 to about 1 percent by weight. The disclosed abrasive particles preferably have a mean particle size in the range of about 5 nm to about 250 nm, more preferably about 50 nm to about 150 nm, as determined by laser light scattering techniques, which are well known in the art.

The disclosed abrasive desirably is suspended in the CMP composition, more specifically in the aqueous component of the CMP composition. When the abrasive is suspended in the CMP composition, the abrasive preferably is colloidally stable. The term "colloid" refers to the suspension of abrasive particles in the liquid carrier. "Colloidal stability" refers to the maintenance of that suspension during a selected period of time with minimal settling. In the context of this invention, an abrasive is considered colloidally stable if, when the abrasive is placed into a 100 mL graduated cylinder and allowed to stand without agitation for a period of time of about 2 hours, the difference between the concentration of particles in the bottom 50 mL of the graduated cylinder ([B] in terms of g/mL) and the concentration of particles in the top 50 mL of the graduated cylinder ([T] in terms of g/mL) divided by the initial concentration of particles in the abrasive composition ([C] in terms of g/mL) is less than or equal to about 0.5 (i.e., ([B] - [T])/[C] ≤0.5). The value of ([B]·[T])/[C] desirably is less than or equal to about 0.3, and preferably is less than or equal to about 0.1.

Oxidizing agents suitable for use in the disclosed CMP compositions and claimed methods of the present invention include, without limitation, hydrogen peroxide, persulfate salts (e.g., ammonium monopersulfate, ammonium dipersulfate, potassium monopersulfate, and potassium dipersulfate), periodate salts (e.g., potassium periodate), and a combination of two or more of the foregoing. Hydrogen peroxide is particularly preferred. Preferably, the oxidizing agent is present in the composition or is utilized in combination with the CMP composition at a concentration in the range of about 0.01 to about 6 percent by weight, more preferably about 0.1 to about 4 percent by weight, based on the combined weight of the composition with hydrogen peroxide incorporated therein.

The disclosed compositions include lysine, preferably at a concentration in the range of about 0.01 to about 5 percent by weight, more preferably about 0.05 to about 2 percent by weight, based on the total composition weight, It is believed that the lysine inhibits PCM oxidation, particularly GST oxidation, and reduces the amount of oxidation products that build-up on the surface of the PCM substrate during CMP in the presence of oxidizing agents, such as hydrogen peroxide.

The disclosed CMP compositions preferably have a pH in the range of about 2 to about 11, more preferably about 2 to about 5, most preferably about 2 to about 4. The CMP compositions can optionally comprise one or more pH buffering materials, for example, ammonium acetate, disodium citrate, and the like, Many such pH buffering materials are well known in the art.

Optionally, the disclosed CMP compositions can include one or more chelating agent capable of chelating a PCM or a component thereof (e.g., germanium, indium, antimony, and/or tellurium species) present in the substrate being polished, or capable of chelating a substance formed therefrom during the CMP process. Disclosed examples of suitable chelating agents include dicarboxylic acids (e.g., oxalic acid, malonic acid, succinic acid, maleic acid, phthalic acid, tartaric acid, aspartic acid, glutamic acid, and the like), polycarboxylic acids (e.g., citric acid, 1,2,3,4-butane tetracarboxylic acid, polyacrylic acid, polymaleic acid, and the like), aminocarboxylic acids (e.g., alpha-amino acids, beta-amino acids, omega-amino acids, and the like), phosphates, polyphosphates, amino phosphonates, phosphonocarboxylic acids, polymeric chelating agents, salts thereof, combinations of two or more of the foregoing, and the like. Preferred chelating agents include oxalic acid, malonic acid, succinic acid, citric acid, salts thereof, and combinations of two or more of the foregoing. The chelating agent, when utilized, preferably is present in the composition at a concentration in the range of about 0.1 to about 3 percent by weight.

In addition, the disclosed CMP compositions can include other optional ingredients such as biocides, dispersants, viscosity modifiers, buffers, pH adjusting agents, metal corrosion inhibitors (e.g., benzotriazoles or 1,2,4-triazoles), and the like.

The disclosed CMP compositions can be prepared by any suitable technique, many of which are known to those skilled in the art. The CMP composition can be prepared in a batch or continuous process. Generally, the CMP composition can be prepared by combining the components thereof in any order. The term "component" as used herein includes individual ingredients (e.g., abrasives, lysine, chelating agents, acids, bases, oxidizing agents, and the like), as well as any combination of ingredients. For example, an abrasive can be dispersed in water, and the lysine can be added, and mixed by any method that is capable of incorporating the components into the CMP composition. The oxidizing agent, when present, can be added to the composition at any suitable time. In some embodiments, the oxidizing agent is not added to the CMP composition until the composition is ready for use in a CMP process, for example, the oxidizing agent is added just prior to initiation of polishing. The pH can be adjusted at any suitable time.

The disclosed CMP compositions also can be provided as a concentrate, which is intended to be diluted with an appropriate amount of an aqueous carrier (e.g., water) prior to use. The CMP composition concentrate can include the various components dispersed or dissolved in the aqueous carrier in amounts such that, upon dilution of the concentrate with an appropriate amount of aqueous carrier, each component of the polishing composition will be present in the CMP composition in an amount within the appropriate range for use.

The present invention provides a chemical-mechanical polishing (CMP) method for polishing a phase change material-containing substrate, the method comprising abrading the surface of the substrate with a CMP composition comprising a) a particulate abrasive, b) lysine, and c) an aqueous carrier therefor in the presence of an oxidizing agent.

A preferred method comprises (i) contacting a surface of a substrate with a polishing pad and a CMP composition as described herein, and (ii) moving the polishing pad relative to the surface of the substrate with the polishing composition therebetween, thereby abrading at least a portion of a PCM from the substrate to polish the surface thereof.

The CMP methods of the present invention can be used to polish any suitable substrate, and are especially useful for polishing substrates comprising a GST alloy, InSb, and the like. Preferably, the PCM is a GST alloy (e.g., Ge₂Sb₂Te₅) or InSb. The substrate preferably also includes a liner material such as Ti or TiN, as well as a layer of silicon dioxide thereunder. In a preferred method, a PCM and a liner layer are abraded, and the abrading is stopped at a silicon dioxide layer.

The CMP methods of the present invention are particularly suited for use in conjunction with a chemical-mechanical polishing apparatus. Typically, the CMP apparatus comprises a platen, which, when in use, is in motion and has a velocity that results from orbital, linear, and/or circular motion. A polishing pad is mounted on the platen and moves with the platen. A carrier assembly holds a substrate to be polished in contact with the pad and moves relative to the surface of the polishing pad, while urging the substrate against the pad at a selected pressure (down force) to aid in abrading the surface of the substrate. A CMP composition is typically pumped onto the polishing pad to aid in the polishing process. The polishing of the substrate is accomplished by the combined abrasive action of the moving polishing pad and the CMP composition of the invention present on the polishing pad, which abrades at least a portion of the surface of the substrate, and thereby polishes the surface.

A substrate can be planarized or polished with a CMP composition of the invention using any suitable polishing pad (e.g., polishing surface). Non-limiting examples of suitable polishing pads include woven and non-woven polishing pads, which can include fixed abrasives, if desired. Moreover, suitable polishing pads can comprise any polymer having any suitable density, hardness, thickness, compressibility, ability to rebound upon compression, and compression modulus, chemical stability, and/or chemical resistance, as is well known in the CMP art. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof.

Desirably, the CMP apparatus further comprises an *in situ* polishing endpoint detection system, many of which are known in the art. Techniques for inspecting and monitoring the polishing process by analyzing light or other radiation reflected from a surface of the workpiece are known in the art. Such methods are described, for example, in U.S. Pat. No. 5,196,353 to Sandhu et al.*,* U.S. Pat. No. 5,433,651 to Lustig et al.*,* U.S. Pat. No. 5,949,927 to Tang, and U.S. Pat. No. 5,964,643 to Birang et al. Desirably, the inspection or monitoring of the progress of the polishing process with respect to a workpiece being polished enables the determination of the polishing end-point, i.e., the determination of when to terminate the polishing process with respect to a particular workpiece.

The following examples further illustrate the disclosed composition and invention but, of course, should not be construed as in any way limiting its scope.

### EXAMPLE 1

This example illustrates the GST-oxidation inhibiting activity of lysine in the presence of hydrogen peroxide.

Individual GST wafers (1 cm-by-1 cm, Ge₂Sb₂Te₅; GST225) were dipped in various aqueous test solutions for about 100 seconds at ambient room temperature. A control solution had a pH of about 3 and comprised about 1 percent by weight hydrogen peroxide in water. Other test solutions included about 1 percent by weight hydrogen peroxide combined with either benzotriazole (BTA; about 0.1 percent by weight), lysine (about 1 percent by weight), or malonic acid (about 3 percent by weight). The wafers had a shiny metallic appearance prior to being dipped into the test solutions. A brown coloration on the surface of the wafer after dipping indicated the formation of a GST oxide layer on the surface. The results of these evaluations and the formulations of the solutions that were tested are shown in Table 1. As the information in Table 1 indicates, lysine effectively and substantially inhibited the formation of a GST oxide coating on the surface of the wafer. BTA had a slight inhibiting effect, whereas hydrogen peroxide alone and hydrogen peroxide combined with malonic acid each formed a significant oxide layer.

**Table 1.**

| **Test Solution** | **Surface Appearance** |
|---|---|
| none, as-received sample | shiny-metallic, no discoloration |
| 1% H₂O₂, pH 3 | brown discoloration |
| 0.1% BTA, 1% H₂O₂, pH 3 | some brown discoloration |
| 1% lysine, 1% H₂O₂, pH 3 | shiny-metallic, slight discoloration |
| 1% lysine, 1% H₂O₂, pH 3 | shiny-metallic, slight discoloration |
| 3% malonic acid, 1% H₂O₂, pH 3 | brown discoloration |

### EXAMPLE 2

This example illustrates the GST-oxidation inhibiting activity of lysine in the presence of hydrogen peroxide using electrochemical measurements.

A GST225 (Ge₂Sb₂Te₅) rotating disc electrode (1 cm diameter) was submerged in an aqueous solution (pH of about 3) containing about 1 percent by weight lysine and about 1 percent by weight hydrogen peroxide. Linear sweep voltametry was performed, and the voltage relative to a standard hydrogen electrode (SHE) was plotted against the log of the corrosion current (log[I]) to provide a Tafel plot (FIG. 1). A Tafel plot also was obtained by the same procedure using a substantially similar GST electrode submerged in an aqueous solution containing about 3 percent by weight malonic acid and about 1 percent hydrogen peroxide at about pH 3 for comparison purposes (FIG. 1). The Tafel plots in FIG. 1 show that the corrosion current for the lysine/hydrogen peroxide solution was about 0.22 mA, while the corrosion current for the malonic acid/hydrogen peroxide solution (no lysine) was about 4.5 mA. For comparison, Tafel plots were obtained for a 1 percent by weight aqueous hydrogen peroxide solution at pH 2.9 and water at pH 2.9 (see FIG. 2). The 1 percent hydrogen peroxide solution had a corrosion current of about 0.2 mA, and water had a corrosion current of about 0.17 mA in these experiments. These results indicate that lysine significantly reduces the GST corrosion current in aqueous hydrogen peroxide at acidic pH compared to the corrosion current obtained with an aqueous solution of malonic acid and hydrogen peroxide.

### EXAMPLE 3

This example illustrates the GST-oxidation inhibiting activity of lysine using x-ray photoemission spectroscopy (XPS).

XPS experiments using depth profiling with Ar-sputtering were performed to determine the oxide layer depths obtained by oxidation of GST225 with 1 percent by weight hydrogen peroxide (pH 3) in the presence of either 0.5 percent by weight lysine or 3 percent by weight malonic acid. The depth measurements were calibrated by sputtering a SiO₂ sample of known depth. The oxidation depths were obtained when the oxidation peaks were absent, after removing about 4 nm of the surface films. The observed oxidation depths are shown in Table 2 (in Angstroms, as SiO₂ equivalent depths). As the data in Table 2 indicate, lysine reduced the oxide layer depth by about 50% for germanium and antimony, and by about 66 percent for tellurium.

**Table 2.**

| **Solution** | **Ge** | **Sb** | **Te** |
|---|---|---|---|
| 3% malonic acid, 1% H₂O₂, pH 3 | 160 Å | 160 Å | 160 Å |
| 0.5% lysine, 1% H₂O₂, pH 3 | 80 Å | 80 Å | 40 Å |

### EXAMPLE 4

This example illustrates the ability of CMP compositions disclosed to effectively remove a GST film in a CMP process as claimed.

Silicon wafers having about 5000Å of Ge₂Sb₂Te₅ film on the surface of the wafer were polished in the presence of about 1 percent by weight of hydrogen peroxide (based on the combined weight of the polishing composition and hydrogen peroxide) on a 200 mm Mirra polisher using a IC1010 polishing pad, with a platen speed of about 93 revolutions-per-minute (rpm), a carrier speed of about 87 rpm, a down pressure of about 4 pounds-per-square inch (psi), and a slurry flow rate of 200 milliliters-per-minute (mL/min). The CMP compositions that were evaluated each contained about 1 percent by weight hydrogen peroxide and had a pH of about 3. Comparative Composition 4A included about 1 percent by weight of colloidal silica (130 nm mean particle size) and about 3 percent by weight malonic acid. Composition 4B (of the invention) included 3.5 percent by weight of the colloidal silica (130 nm mean particle size) and about 0.5 percent by weight lysine. The GST removal rates (RR) are shown in Table 3.

**Table 3**

| **Composition** | | **GST RR (Å/min)** |
|---|---|---|
| 4A | 1 % abrasive, 3% malonic acid | 1200 |
| 4B | 3.5 % abrasive 0.5% lysine | 1935 |

Comparative Composition 4A represents a composition as taught by co-owned and co-pending U.S. Patent Application Serial No. 11/699,129 (Dysard et al.), which teaches the use of not more than about 3 percent by weight of abrasive in combination with malonic acid and similar materials. The removal rate shown in Table 3 for Composition 4B indicates that the compositions of the invention can achieve excellent GST removal rates even without malonic acid present.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. A chemical-mechanical polishing (CMP) method for polishing a phase change material-containing substrate, the method comprising abrading the surface of the substrate with a CMP composition of comprising:
(a) a particulate abrasive,
(b) lysine; and
(c) an aqueous carrier therefor, in the presence of an oxidizing agent.

2. The chemical-mechanical polishing (CMP) method for polishing of claim 1, the method comprising the steps of:
(a) contacting a surface of the substrate with a polishing pad and the aqueous CMP composition in the presence of an oxidizing agent; and
(b) causing relative motion between the polishing pad and the substrate while maintaining a portion of the CMP composition in contact with the surface between the pad and the substrate for a period of time sufficient to abrade at least a portion of the phase change material from the substrate.

3. The CMP method of claim 2 wherein the oxidizing agent comprises at least one material selected from the group consisting of hydrogen peroxide, a persulfate salt, a periodate salt, and a salt thereof.

4. The CMP method of claim 2 wherein the oxidizing agent comprises hydrogen peroxide.

5. The CMP method of claim 2 wherein the oxidizing agent is present at a concentration in the range of about 0.01 to about 6 percent by weight.

6. The CMP method of claim 2 wherein the substrate comprises a surface layer of a germanium-antimony-tellurium (GST) alloy.

7. The CMP method of claim 6 wherein the substrate further comprises a liner material under the surface layer.

8. The CMP method of claim 7 wherein the liner material is selected from the group consisting of Ti, TiN, and a combination thereof.

9. The CMP method of claim 7 wherein the substrate further comprises a layer of silicon dioxide under the liner material.

10. The CMP method of claim 9 wherein the GST alloy and the liner material are each abraded, and the abrading is ceased at the silicon dioxide layer.

11. The CMP method of claim 2 wherein the substrate comprises indium antimonite (InSb).

## Patentansprüche

1. Ein chemisch-mechanisches Polier-(CMP)-Verfahren für das Polieren eines Latentwärmespeicher-enthaltenden Substrats, das Verfahren weist dabei das Abschleifen der Oberfläche des Substrats mit einer CMP-Zusammensetzung auf, die Folgendes aufweist:
(a) ein Partikel-Schleifmittel,
(b) Lysin; und
(c) einen wässrigen Trägerstoff dafür, in Gegenwart eines Oxidationsmittels.

2. Das chemisch-mechanische Polier-(CMP)-Verfahren für das Polieren gemäß Anspruch 1, das Verfahren weist dabei die folgenden Schritte auf:
(a) die Kontaktierung einer Oberfläche des Substrats mit einem Polierkissen und der wässrigen CMP-Zusammensetzung in Gegenwart eines Oxidationsmittels; und
(b) die Herbeiführung einer relativen Bewegung zwischen dem Polierkissen und dem Substrat, während ein Teil der CMP-Zusammensetzung solange in Kontakt mit der Oberfläche zwischen dem Kissen und dem Substrat bleibt bis zumindest ein Teil des Latentwärmespeichers vom Substrat abgeschliffen ist.

3. Das CMP-Verfahren gemäß Anspruch 2, wobei das Oxidationsmittel mindestens ein Material aufweist, ausgewählt aus der Gruppe bestehend aus Wasserstoffperoxid, einem Persulfatsalz, einem Periodatsalz und einem Salz daraus.

4. Das CMP-Verfahren gemäß Anspruch 2, wobei das Oxidationsmittel Wasserstoffperoxid aufweist.

5. Das CMP-Verfahren gemäß Anspruch 2, wobei das Oxidationsmittel in einer Konzentration im Bereich von ungefähr 0,01 bis ungefähr 6 Gewichtsprozent vorhanden ist.

6. Das CMP-Verfahren gemäß Anspruch 2, wobei das Substrat eine Oberflächenschicht einer Germanium-Antimon-Tellur (GST)-Legierung aufweist.

7. Das CMP-Verfahren gemäß Anspruch 6, wobei das Substrat darüberhinaus ein Auskleidungsmaterial unter der Oberflächenschicht aufweist.

8. Das CMP-Verfahren gemäß Anspruch 7, wobei das Auskleidungsmaterial ausgewählt ist aus der Gruppe bestehend aus Ti, TiN und einer Kombination daraus.

9. Das CMP-Verfahren gemäß Anspruch 7, wobei das Substrat darüberhinaus ein Silikondioxid unter dem Auskleidungsmaterial aufweist.

10. Das CMP-Verfahren gemäß Anspruch 9, wobei die GST-Legierung und das Auskleidungsmaterial jeweils geschliffen sind, und das Abschleifen an der Silikondioxidschicht endet.

11. Das CMP-Verfahren gemäß Anspruch 2, wobei das Substrat Indiumantimonid (InSb) aufweist.

## Revendications

1. Un procédé de polissage mécanico-chimique (CMP) destiné au polissage d'un substrat contenant un matériau à changement de phase, le procédé comprenant l'abrasion de la surface du substrat avec une composition CMP contenant :
(a) un abrasif particulaire,
(b) de la lysine, et
(c) un vecteur aqueux à cet effet en présence d'un agent oxydant.

2. Le procédé de polissage mécanico-chimique (CMP) destiné à un polissage selon la Revendication 1, le procédé comprenant les opérations suivantes :
(a) la mise en contact d'une surface du substrat avec un tampon de polissage et la composition CMP aqueuse en présence d'un agent oxydant, et
(b) la provocation d'un mouvement relatif entre le tampon de polissage et le substrat tout en maintenant une partie de la composition CMP en contact avec la surface entre le tampon et le substrat pendant une période temporelle suffisante pour abraser au moins une partie du matériau à changement de phase du substrat.

3. Le procédé CMP selon la Revendication 2 où l'agent oxydant contient au moins un matériau sélectionné dans le groupe se composant de peroxyde d'hydrogène, d'un sel de persulfate, d'un sel de périodate, et d'un sel de ceux-ci.

4. Le procédé CMP selon la Revendication 2, où l'agent oxydant contient du peroxyde d'hydrogène.

5. Le procédé CMP selon la Revendication 2, où l'agent oxydant est présent à une concentration dans la plage d'environ 0,01 à environ 6% en poids.

6. Le procédé CMP selon la Revendication 2, où le substrat comprend une couche de surface d'un alliage de germanium-antimoine-tellure (GST).

7. Le procédé CMP selon la Revendication 6, où le substrat contient en outre un matériau de revêtement sous la couche de surface.

8. Le procédé CMP selon la Revendication 7, où le matériau de revêtement est sélectionné dans le groupe se composant de Ti, TiN et d'une combinaison de ceux-ci.

9. Le procédé CMP selon la Revendication 7, où le substrat contient en outre une couche de dioxyde de silicium sous le matériau de revêtement.

10. Le procédé CMP selon la Revendication 9 où l'alliage GST et le matériau de revêtement sont chacun abrasés et l'abrasion est cessée au niveau de la couche de dioxyde de silicium.

11. Le procédé CMP selon la Revendication 2 où le substrat contient de l'antimonite d'indium (InSb).
